# EUROPÄISCHE PATENTSCHRIFT

(11) **EP 1 625 644 B1**
(45) Veröffentlichungstag und Bekanntmachung des Hinweises auf die Patenterteilung: **23.08.2006**
(21) Anmeldenummer: 04730952.1
(22) Anmeldetag: 04.05.2004
(51) Int. Cl.: H01S 5/065

(54) **MODENGEKOPPELTE HALBLEITERLASER-PULSQUELLE**
MODE-LOCKED SEMICONDUCTOR LASER PULSE SOURCE
SOURCE D'IMPULSIONS DE LASER SEMICONDUCTEUR COUPLAGE DE MODES

(30) Priorität: 10.05.2003 DE 10322112
(43) Veröffentlichungstag der Anmeldung: 15.02.2006
(73) Patentinhaber: Fraunhofer-Gesellschaft zur Förderung der angewandten Forschung e.V., 80686 München (DE)
(72) Erfinder: KAISER, Ronald, 12157 Berlin (DE); FIDORRA, Sybille, 13647 Berlin (DE); HEIDRICH, Helmut, 12357 Berlin (DE); HÜTTL, Bernd, 12623 Berlin (DE)
(74) Vertreter: Schubert, Helmut
(86) Internationale Anmeldenummer: PCT/DE2004/000939
(87) Internationale Veröffentlichungsnummer: WO 2004/102753

(56) Entgegenhaltungen:
- HUETTL B ET AL OPTICAL SOCIETY OF AMERICA / INSTITUTE OF ELECTRICAL AND ELECTRONICS ENGINEERS: "Monolithic mode-locked laser on GaInAsP/InP for 160Gb/s TDM applications" OPTICAL FIBER COMMUNICATION CONFERENCE. (OFC). POSTCONFERENCE DIGEST. ATLANTA, GA, MARCH 23 - 28, 2003, TRENDS IN OPTICS AND PHOTONICS SERIES. (TOPS), WASHINGTON, DC : OSA, US, Bd. TOPS. VOL. 86, 23. März 2003 (2003-03-23), Seiten 675-676, XP010680422 ISBN: 1-55752-746-6 in der Anmeldung erwähnt
- DERICKSON D J ET AL: "Short Pulse Generation Using Multisegment Mode-Locked Semiconductor Lasers" IEEE JOURNAL OF QUANTUM ELECTRONICS, IEEE INC. NEW YORK, US, Bd. 28, Nr. 10, 10. Oktober 1992 (1992-10-10), Seiten 2186-2201, XP002975392 ISSN: 0018-9197
- HOSHIDA T ET AL: "Detuning characteristics of a subharmonically hybrid mode-locked monolithic semiconductor laser" SEMICONDUCTOR LASER CONFERENCE, 1996., 15TH IEEE INTERNATIONAL HAIFA, ISRAEL 13-18 OCT. 1996, NEW YORK, NY, USA,IEEE, US, 13. Oktober 1996 (1996-10-13), Seiten 59-60, XP010199251 ISBN: 0-7803-3163-X

## Beschreibung

Die Erfindung bezieht sich auf eine modengekoppelte Halbleiterlaser-Pulsquelle für den Ultrahochfrequenzbereich in monolithisch integriertem Wellenleiter-Schichtaufbau auf InP-Basis mit einem Abstimmungsbereich Δfᵣₑₚ für die erzeugte Pulsfolgefrequenz fᵣₑₚ mit zumindest einer von einem Verstärkerstrom I_{gain} durchflossenen Verstärkersektion der gewählten Länge L_{gain} und einer sättigbaren Absorbersektion der gewählten Länge L_{absorb} mit einer angelegten Absorberspannung U_{absorb} als aktivem Laserbereich in Linearanordnung sowie mit einem n-leitenden- und einem p-leitenden Anschlusskontakt.

Monolithisch integrierte, moden-gekoppelte Halbleiterlaser-Pulsquellen, die in Linearanordnung eine aktive Verstärker- und sättigbare Absorbersektion, aber auch zusätzlich eine passive Gitter- und eine Phasensektion enthalten können, sind in unterschiedlicher Bauweise bereits seit Anfang der 90er Jahre Bestandteil der Forschung und Technik. Die Phasensektion wird dabei i.a. zum Abstimmen der Pulsfolgefrequenz durch Strominjektion genutzt. In diesem Fall wird der Brechungsindex des Laserwellenleiters gesenkt und damit durch Reduktion der optischen Länge des Resonators die Pulsfolgefrequenz erhöht. Es ist auch bekannt, einen Heizstreifen innerhalb der Linearanordnung zu integrieren, mit der die Pulsfolgefrequenz verkleinert werden kann, da die im Heizstreifen durch Strominjektion erzeugte thermische Energie den Brechungsindex im Laserwellenleiter und damit die optische Länge des Resonators erhöht. Heutige monolithisch integrierte Pulsquellen erzeugen Pulsfolgefrequenzen von 20 GHz und mehr bei Pulsbreiten von 2 ps. Ein besonderes Problem bei derartig schnellen Pulsquellen ist die genaue Einstellung der zu erzeugenden Pulsfolgefrequenz fᵣₑₚ (z.B. auf 10⁻⁵). Herstellungsbedingt entstehen hier große Abweichungen, die an der fertigprozessierten Pulsquelle durch Abstimmung ausgeregelt werden müssen. Um eine möglichst hohe Produktivität bei der Herstellung der Pulsquellen zu erreichen, ist es erforderlich, deren Ausschussrate möglichst gering zu halten. Da die jeweils erreichte Pulsfolgefrequenz fᵣₑₚ aber stark variieren kann, wird ein entsprechend großer Abstimmungsbereich Δfᵣₑₚ benötigt. Verschiedene Druckschriften beschäftigen sich mit dieser Problematik. Dabei gehen die verschiedenen bekannten Wellenleiter-Schichtaufbauten von unterschiedlichen Längen L_{absorb} der Absorbersektion und L_{gain} der Verstärkersektion aus.

Aus der **Veröffentlichung I** von S. Arahira et al.: "Repetition-Frequency Tuning of Monolithic Passively Mode-Locked Semiconductor Lasers with Integrated Extended Cavities" (IEEE J. Quantum Electron., vol. 33, no. 2, pp. 255-264, 1997) ist eine Pulsquelle mit einer Absorberlänge L_{absorb} von 50 µm und einer Verstärkerlänge L_{gain} von 940 µm bekannt, bei der die Abstimmbarkeit durch verschiedene Maßnahmen getestet wird. Hierbei handelt es sich um eine Längenvariation einer zusätzlichen passiven Kavitätssektion, die im Ergebnis einen linearen Zusammenhang von deren Länge und der inversen Pulsfolgefrequenz fᵣₑₚ gezeigt hat, und um Änderungen der Absorberspannung U_{absorb} und des Verstärkerstroms I_{gain}. In der **Veröffentlichung II** von D. Kunimatsu et al.: "Passively Mode-Locked Laser Diodes with Bandgap-Wavelength Detuned Saturable Absorbers" (IEEE Photon. Technol. Lett., vol. 11, no. 11, pp. 1363-1365, 1999) wird eine Pulsquelle mit einer Absorberlänge L_{absorb} von 70 µm und einer Verstärkerlänge L_{gain} von 1025 µm beschrieben, bei der Abstimmung durch eine Verstimmung der Bandlücken-Wellenlänge des Absorbers herbeigeführt werden soll. Aus der **Veröffentlichung III** von S. Arahira et al.: "Extreme Timing Jitter Reduction of a Passively Mode-Locked Laser Diode by Optical Pulse Injection" (IEEE J. Quantum Electron., vol. 35, no. 12, pp. 1805-1811, 1999) ist eine Pulsquelle mit einer Absorberlänge L_{absorb} von 50 µm und einer Verstärkerlänge L_{gain} von 780 µm bekannt, bei der durch optische Pulsinjektion bei Veränderung der Vorspannung an Absorber- und Verstärkersektion eine Stabilisierung der Pulsfolgefrequenz fᵣₑₚ erreicht werden soll. Aus der **Veröffentlichung IV** von H.F. Liu et al.: "Tuning Characteristics of Monolithic Passively Mode-locked Distributed Bragg Reflector Semiconductor Lasers" (IEEE J. Quantum Electron., vol. 32, no. 11, pp. 1965-1975, 1996) ist es außerdem bekannt, bei einer ähnlichen Pulsquelle mit einer Absorberlänge L_{absorb} von 75 µm und einer Verstärkerlänge L_{gain} von 750 µm einen 200 µm-breiten Heizstreifen als Phasensektion zu integrieren. Die in diesen zitierten Veröffentlichungen angegebenen erreichbaren Abstimmungsbereich Δfᵣₑₚ erreichen aber immer noch nicht eine Größe, mit der alle gefertigten Pulsquellen zuverlässig abgestimmt werden können. Außerdem werden keine Aussagen darüber gemacht, wie zur Erzielung einer möglichst großen Pulsfolgefrequenz-Abstimmung das Verhältnis der Baulängen von Verstärker- zur Absorbersektion unter bestimmten Randbedingungen auszulegen ist. Die erwähnten Wellenleiter-Schichtaufbauten zeigen ganz unterschiedliche Längen L_{absorb} der Absorbersektion und L_{gain} der Verstärkersektion auf, die einzelne, willkürlich gewählte diskrete Verhältnisse bilden und sich lediglich auf die Anwendung der Erkenntnis beschränken, dass die Absorberlänge stets kleiner als die Verstärkerlänge zu sein hat.

Eine systematische Wahl der Sektionslängen durch deren gegenseitige Verhältnisbildung ist dagegen aus der **DE 43 01 830 A1** bekannt. Hierbei handelt es sich jedoch um die Dimensionierung von drei Sektionen eines DFB-Halbleiterlasers für den Einsatz als abstimmbarer Laser im Wellenlängenbereich. Alle Sektionen enthalten ein Gitter, deren Wirkung durch einen Kopplungskoeffizienten ausgedrückt wird. Aus der **US 2001/0046250 A1** ist hingegen ebenfalls eine optische Pulsquelle mit einer Absorber- und einer Verstärkersektion bekannt, die in ein vorgegebenes Verhältnis gebracht worden sind. Hierbei handelt es sich aber lediglich um eine Summenformel zur Ermittlung der Gesamtlänge der Pulsquelle in Verbindung mit einem koppelnden optischen System und der antiproportionalen Abhängigkeit dieser Gesamtlänge von der Pulsfolgefrequenz. Deren Variation erfolgt dann über die Wahl der effektiven Länge eines Faser-Bragg-Gitters. Bezüglich der Absorber- und Verstärkerlängen wird wiederum nur postuliert, dass die Absorberlänge wesentlich kleiner als die Verstärkerlänge sein soll. Diese Erkenntnis wird aber nicht bezüglich des Abstimmverhaltens der Pulsfolgefrequenz eingesetzt, sondern bezieht sich auf die eigentliche Funktion der Modenkopplung. Eine zu lange Absorbersektion im Verhältnis zur Verstärkersektion würde aufgrund zu hoher Verluste eine effektive Modenkopplung verhindern bzw. je nach Länge bei den vorgegebenen Ansteuerbedingungen sogar verhindern.

Aus der **Veröffentlichung V** von R. Kaiser et al.: "Tunable mode-locked lasers on GaInAsP/InP with 2 ps pulses and low timing jitter" (Internat. Semiconductor Laser Conf. (ISLC) 2002, post-deadline paper #PD2, Garmisch-Partenkirchen (D), 2002) ist eine gattungsgemäße modengekoppelte Halbleiterlaser-Pulsquelle für den Ultrahochfrequenzbereich in monolithisch integriertem Wellenleiter-Schichtaufbau auf InP-Basis bekannt, bei der verschiedene Verstärkerlängen (L_{gain} = 460 µm und 560 µm) bei einer Absorberlänge (L_{absorb} = 50 µm) zur Erzielung eines möglichst großen Abstimmungsbereichs Δfᵣₑₚ der Pulsfolgefrequenz fᵣₑₚ getestet wurden. Weiterhin wurden auch Gittersektionen zur Bestimmung der Emissionswellenlänge und Phasen-, Heizstreifensektionen zum weiteren Tuning der Pulsfolgefrequenz fᵣₑₚ eingesetzt. Zum selben Zweck wurde das Pulsverhalten bei Aufprägung eines externen Hochfrequenzsignals an den Absorber untersucht ("hybride Modenkopplung"). Insgesamt konnte eine Vergrößerung des Abstimmungsbereichs Δfᵣₑₚ festgestellt werden. Diese wurde aber nicht in direkten Zusammenhang mit den verschiedenen Sektionslängen gebracht. Gleiches gilt für die **Veröffentlichung VI** von B. Hüttl et al.: "Monolithic mode-locked laser on GaInAsP/InP for 160 Gb/s TDM applications" (Proc. of Optical Fiber Communication Conference 2002, USA, 2002), von der die vorliegende Erfindung als nächstliegendem Stand der Technik ausgeht und die das Ziel hat, durch eine Variation der Sektionslängen die optimalen Dimensionen für ein zuverlässig reproduzierbares Design einer Pulsquelle mit einem möglichst großen Abstimmungsbereich Δfᵣₑₚ zu ermitteln. Konkrete Längen- oder Verhältnisangaben werden aber nicht gemacht. Im Ergebnis wird jedoch ein Abstimmungsbereich Δfᵣₑₚ von bis zu 400 MHz durch Variation des Verstärker- und Phasenstroms bei einer angepassten Absorberspannung zur Erzeugung möglichst schmaler Lichtpulse unter 2 ps erreicht. Eine weitere Abstimmung wird durch die erstmalige Vereinigung von elektronischem und thermischem Resonatortuning auf einem Chip erzielt. Die so optimierte Pulsquelle kann zur Erzeugung einer Pulsfolgefrequenz von 160 GHz aus vier zeitlich versetzten Pulsfolgen mit einer Pulsfolgefrequenz von 40 GHz verwendet werden und zeigt dabei nur einen Zeitjitter von unter 230 fs.

In Weiterentwicklung der aus der **Veröffentlichung VI** bekannten gattungsgemäßen modengekoppelte Halbleiterlaser-Pulsquelle für den Ultrahochfrequenzbereich in monolithisch integriertem Wellenleiter-Schichtaufbau auf InP-Basis ist es daher die **Aufgabe** für die vorliegende Erfindung, für eine möglichst kostengünstige und zuverlässig reproduzierbare Herstellung derartiger Pulsquellen eine Designregel anzugeben, mit der durch Realisierung einfacher konstruktiver Auflagen ein möglichst großer Abstimmungsbereich Δfᵣₑₚ erreicht werden kann. Dieser soll möglichst ausschließlich durch eine variierende Beaufschlagung des aktiven Laserbereichs, der aus der sättigbaren Absorber- und der Verstärkersektion besteht, durchfahrbar sein, sodass zusätzliche Abstimmungssektionen entfallen können.

Als **Lösung** für diese Aufgabe ist bei einer gattungsgemäßen Pulsquelle der eingangs beschriebenen Art deshalb erfindungsgemäß vorgesehen, dass der Abstimmungsbereich Δfᵣₑₚ der Pulsfolgefrequenz fᵣₑₚ durch das gewählte Längenverhältnis Γ der Länge L_{gain} der Verstärkersektion zur Länge L_{absorb} der Absorbersektion nach der Geradengleichung Δfᵣₑₚ = c - m· Γ mit den streuwertbehafteten Konstanten c = 304 ± 50 und m = 61,4 ± 5 bei einer jeweiligen Änderung ΔI_{gain} des Verstärkerstroms I_{gain} um 70 mA und einer simultanen Anpassung der voreingestellten Absorberspannung U_{absorb} zwischen -1 V und -4 V zur Erzeugung konstanter, minimaler Pulsbreiten kontinuierlich definiert ist. Vorteilhafte Weiterbildungen der Erfindung sind den Unteransprüchen zu entnehmen, die nachfolgend und im speziellen Beschreibungsteil im Zusammenhang mit der Erfindung im Einzelnen näher erläutert werden.

Die erfindungsgemäße Pulsquelle weist ein genau abgestimmtes Verhältnis von Absorber- zu Verstärkerlänge auf. Diese kann aus einem linearen Zusammenhang zwischen beiden Größen ermitteln und damit kontinuierlich festgelegt werden. Im Gegensatz dazu kennt der Stand der Technik nur diskrete Längenverhältnisse, die mehr oder weniger willkürlich zusammengestellt worden sind und damit nicht die geforderten Ergebnisse gebracht haben. Über den linearen, kontinuierlichen Zusammenhang kann nunmehr bei der erfindungsgemäßen Pulsquelle in Abhängigkeit von der geforderten Breite des Abstimmungsbereichs Δfᵣₑₚ eine optimale Längenkombination von Absorber- und Verstärkersektion ermittelt werden. Zum einen kann diese genau reproduziert werden, zum anderen können durch die Herstellung auftretende Abweichungen mit zunehmender Breite des Abstimmungsbereichs Δfᵣₑₚ erfolgreich kompensiert werden. Die durch die Erfindung erzielte Laserstruktur ermöglicht eine Erhöhung des Abstimmbereiches Δfᵣₑₚ der Pulsfolgefrequenz fᵣₑₚ mit Vergrößerung des Verhältnisses r von Verstärkerlänge zu Absorberlänge (Γ = L_{gain}/L_{absorb}) ohne zusätzliche Abstimmsektionen (Phasensektion, Heizstreifensektion). Die Kompensation herstellungsbedingter Pulsfolgefrequenzabweichungen kann somit in der Regel bei üblichen Herstellungsabweichungen allein durch eine Ansteuerung der grundsätzlich erforderlichen Verstärker- und Absorbersektion erreicht werden.

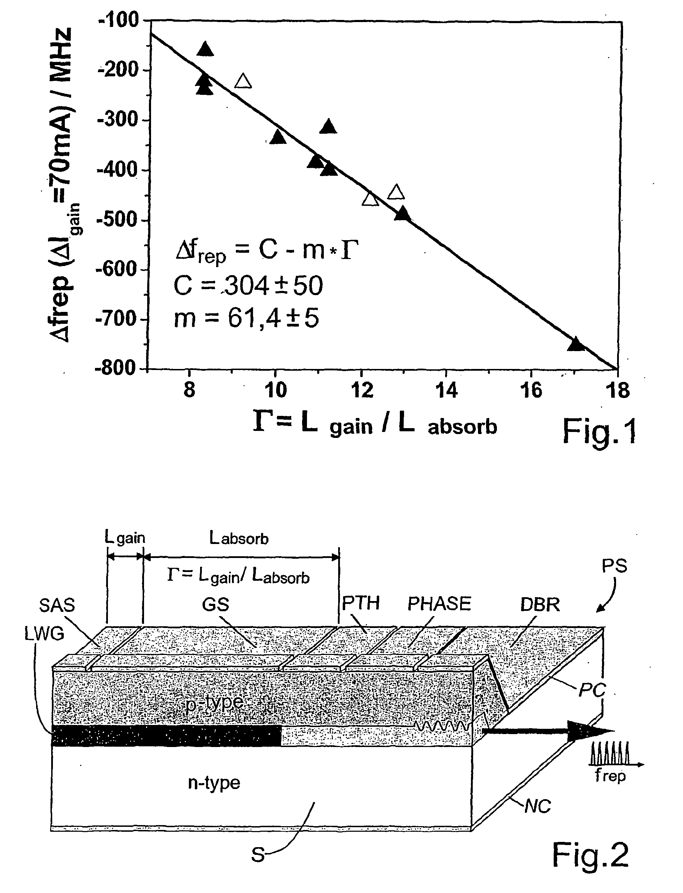

Im Vergleich zu den uns bisher aus Veröffentlichungen bekannten Werten für vergleichbare Strukturen, sind die mit der vorliegenden Struktur erzielten Werte eindeutig größer. An fertiggestellten Laserstrukturen konnten experimentell Verschiebungen der Pulsfolgefrequenz fᵣₑₚ von bisher maximal 700 MHz durch eine Erhöhung des Verstärkerstromes um 70 mA und einer simultanen Anpassung der Absorberspannung zwischen -1 V und -4 V erzielt werden. Die maximal erreichbaren Verschiebungen der Pulsfolgefrequenz fᵣₑₚ bei den genannten Ansteuerbedingungen sind für unterschiedlich gewählte Längenverhältnisse in der Figur 1 des speziellen Beschreibungsteils dargestellt und folgen einer linearen Abhängigkeit. Bei einer geeigneten Wahl des Längenverhältnisses Γ ist ein Abstimmbereich realisierbar, der es ermöglicht, unerwünschte Frequenzverschiebungen am Ende eines Produktionsprozesses in Bezug auf einen geforderten Spezifikationswert, die unvermeidbar durch technologische Genauigkeitsschwankungen während der Herstellung auftreten, zuverlässig auszugleichen, sodass eine hohe Produktivität erreicht werden kann. Der große Vorteil hierbei ist es, dass diese Kompensation der Pulsfolgefrequenz fᵣₑₚ in der Regel ohne zusätzlich erforderliche Abstimmungselemente, wie sie i.a. in der Literatur zur Frequenzabstimmung für vergleichbare Laserstrukturen beschrieben werden (elektronisch oder thermisch gesteuerte Phasensektionen) zu erreichen ist. Möglich wird dieser Vorteil auch durch die großen Lock- oder Ziehbereiche (locking bandwidth) der Pulsfolgefrequenz fᵣₑₚ bezüglich extern anliegender Hochfrequenzsignale. Innerhalb der genannten Frequenzbereiche wurden Werte zwischen 100 MHz und 500 MHz gemessen (bei einer externen HF-Leistung von 20..24 dBm am Absorber-Anschlusskontakt). Insgesamt gesehen ermöglicht die realisierte Bauelementstruktur nach der Erfindung mit dem hier beschriebenem Abstimmverhalten sowohl eine einfachere Ansteuerung (Bedienung) der Halbleiterlaser-Pulsquelle für den Anwender als auch - aufgrund des relativ breiten Abstimmbereichs Δfᵣₑₚ der Pulsfolgefrequenz fᵣₑₚ - eine kostengünstigere Fertigung für den Hersteller (höhere Ausbeute, kleinerer Aufwand). Die beschriebenen Ergebnisse und Zusammenhänge basieren auf der hier beschriebenen Laserstruktur die durch eine Reihe von konstruktiven Modifizierungsmaßnahmen im Vergleich zum bisherigen Stand der Technik gekennzeichnet ist.. Diese werden im Folgenden zusammen mit der Erfindung näher erläutert.

**Ausbildungsformen** der modengekoppelten Halbleiterlaser-Pulsquelle (im Folgenden kurz Pulsquelle) für den Ultrahochfrequenzbereich in monolithisch integriertem Wellenleiter-Schichtaufbau auf InP-Basis nach der Erfindung werden nachfolgend anhand der schematischen Figuren näher erläutert. Dabei zeigt :
- **Figur 1**: ein Diagramm zum linearen Zusammenhang zwischen den aktiven Sektionslängen,
- **Figur 2**: eine Pulsquelle im räumlichen Querschnitt,
- **Figur 3**: eine modifizierten Pulsquelle in der Aufsicht,
- **Figur 4**: die Pulsquelle gemäß Figur 3 im Querschnitt,
- **Figur 5**: ein REM-Foto der Pulsquelle gemäß Figur 3 ,
- **Figur 6**: eine weitere modifizierte Pulsquelle in der Aufsicht,
- **Figur 7**: die Pulsquelle gemäß Figur 6 im Querschnitt und
- **Figur 8**: einen modifizierten Übergang zwischen aktivem und passivem Laserbereich in der Pulsquelle.

Die **Figur 1** zeigt die experimentell ermittelte, maximale Verschiebung der Pulsfolgefrequenz **Δf**_{**rep**} in MHz für eine Änderung des Verstärkerstromes **I**_{**gain**} von 80 mA auf 150 mA (**ΔI**_{**gain**}= 70 mA) in Abhängigkeit vom Verhältnis Γ der Länge der Verstärkersektion **L**_{**gain**} zur Länge der Absorbersektion **L**_{**absorb**} für verschiedene Pulsquellen nach der Erfindung, die auf zwei unterschiedlichen Wafern (helle/dunkle Dreiecke) hergestellt wurden. Die Spannung an der sättigbaren Absorbersektion **U**_{absorb} wird zur Erzeugung konstanter, minimaler Pulsbreiten mit zunehmendem Verstärkerstrom **I**_{gain} entsprechend angepasst (hier zwischen -1V und -4V). Deutlich ist der lineare Zusammenhang zu erkennen, der sich durch die Gleichung **Δf**_{**rep**} **= c - m · Γ** mit den streuwertbehafteten Konstanten c= 304 ± 50; m: 61,4 ± 5 beschreiben lässt, wobei die beiden Konstanten jeden Wert aus dem jeweiligen Streuwertbereich (254 ≤ c ≤ 354 und 56,4 ≤ m ≤ 66,4) annehmen können, sodass sich eine entsprechende Geradenschar ergibt. Für die mittleren Werte c = 304 und m = 61,4 ergibt sich ein Regressionskoeffizient von -0,981, der eine sehr gute Linearität des ermittelten Zusammenhangs zeigt. Anhand dieses den Graphen beschreibenden Zusammenhangs bzw. anhand des Graphen selbst kann nun vom Anwender für eine gattungsgemäße Halbleiterlaser-Pulsquelle unter den genannten Voraussetzungen bei einer entsprechenden Wahl des Verhältnisses r der gezeigte Abstimmungsbereich Δfᵣₑₚ der Pulsfolgefrequenz **f**ᵣₑₚ ausschließlich durch eine Variation der Verstärkerstroms **I**_{gain} mit einer angepassten Absorberspannung **U**_{absorb} herbeigeführt werden. Dabei sind bei großen gewählten Verhältnissen Γ im Bereich von 17 große Abstimmbereiche Δfᵣₑₚ im Bereich von 750 MHz erreichbar. Dabei ist eine Pulsdauer von unter 2 ps bei einem geringen Zeitjitter von 230 ± 30 fs für eine Pulsquelle auf Basis von GaInAsP/InP für 40 GHz erzielbar.

Die **Figur 2** zeigt eine monolithisch integrierte Pulsquelle **PS** nach der Erfindung, die neben einer sättigbaren Absorbersektion **SAS** zur Erzeugung kurzer Lichtpulse und einer Verstärkersektion **GS** auch eine emissionswellenlängenselektive Gittersektion **DBR** und eine zusätzliche Phasensektion **PHASE** zur elektronischen Einstellung der Pulsfolgefrequenz **f**_{**rep**} und eine zusätzliche Heizstreifensektion **PTH** zur gleichzeitigen thermischen Einstellung der Pulsfolgefrequenz **f**_{**rep**} in einer Linearanordnung **LA** enthält. Die gezeigte Pulsquelle PS ist somit nicht nur über die Wahl des Verhältnisses Γ (vgl. Figur 1) bezüglich der Pulsfolgefrequenz **f**_{**rep**} vor- und durch den Verstärkerstrom I_{gain} nacheinstellbar, sondern auch durch die Phasensektion **PHASE** und die Heizstreifensektion **PTH** zusätzlich im Feinstbereich nach der Herstellung einstellbar. Damit ergibt sich eine optimale Einstellbarkeit. Zur Lichtführung weist die Pulsquelle **PS** einen vergrabenen Laserwellenleiter **LWG** auf, der im Bereich der sättigbaren Absorbersektion **SAS** und der Verstärkersektion **GS** aktiv (dunkel) und dahinter passiv (hell) ausgebildet ist, wobei beide Laserbereiche (aktiv und passiv) mittels selektiver Epitaxie hergestellt in Stoßkopplung miteinander verbunden sind. Zur Stromblockierung seitlich des Laserwellenleiters **LWG** kann entweder eine konventionelle pn-Schichtenfolge oder eine semi-isolierende Schichtenfolge (z.B. InP:Fe) gewachsen werden. Der aktive Laserwellenleiter **LWG** besteht aus einer Multi-Quantum-Well-Schichtenfolge, kann jedoch auch als Volumenmaterial ausgelegt werden. Der p-leitende Bereich **p-type** wird im gezeigten Ausführungsbeispiel durch eine Zn-Dotierung von InP erzeugt, das n-leitende Substrat **n-type S** hingegen besteht aus Sn-dotiertem InP.

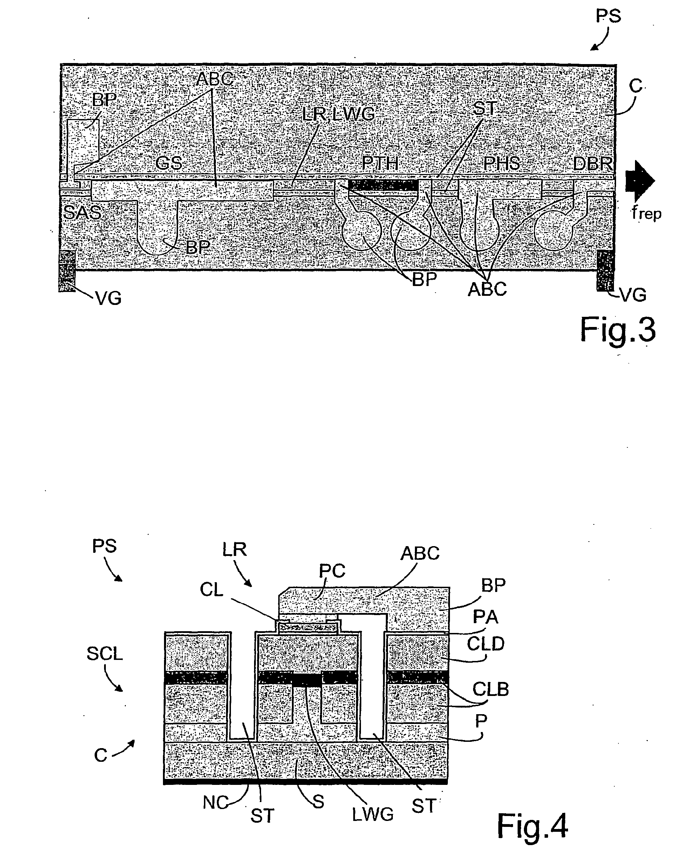

Für die Nutzung der Vorteile einer hybriden Modenkopplung werden die dafür erforderlichen, extern erzeugten Hochfrequenzsignale der Pulsquelle **PS** über einen Anschlusskontakt (vgl. Figur 4) des sättigbaren Absorbers **SAS** zugeführt. Sowohl diese hochfrequente als auch die für die anderen Sektionen notwendige, kontinuierliche Stromzuführung erfolgt über die entsprechenden P-Kontakte **PC** der integrierten Sektionen. Der gemeinsame N-Kontakt **NC** ist auf der Rückseite des n-dotierten Halbleiter-Substrates **n-type S** angeordnet. Die Lichtauskopplung erfolgt an der Seite der Gittersektion **DBR,** die mit einer geeigneten Anti-Reflexionsschicht belegt ist. Die hintere Laserfacette an der Seite der sättigbaren Absorbersektion **SAS** wird nach dem Spalten entweder nicht beschichtet oder mit einer geeigneten, hochreflektierenden Schicht belegt (in der Figur 2 nicht dargestellt).

Die **Figur 3** zeigt eine schematische Darstellung einer monolithisch integrierten Pulsquelle **PS** in Aufsicht mit den unterschiedlichen Sektionen sowie einigen strukturellen Neuerungen, bei denen es sich handelt um: a) eine laterale Beschränkung einer den Laserwellenleiter **LWG** umfassenden Laserrippe **LR** auf eine Breite von ≤10 µm durch Ätzung eines tiefen (≥3 µm) Trenngrabens **ST** auf jeder Seite des Laserwellenleiters **LWG,** b) eine galvanisch verstärkte Kontaktführung mittels Luftbrücken **ABC** von einem Bondpad **BP** (Anschlusskontakt) zur Laserrippe **LR,** c) die Integration einer Phasensektion **PHS** und einer Heizstreifensektion **PTH** zur zusätzlichen Beeinflussung der Pulsfolgefrequenz **f**_{**rep**} bzw. der Phasen der im Laserwellenleiter **LWG** zu koppelnden Moden, d) Definition und Strukturierung von tiefen, V-förmigen Spaltgruben bzw. Spaltgrubenreihen **VG** am Waferrand oder in der Nähe der zu vereinzelnden Pulsquellen **PS.** Für eine effektive externe Hochfrequenzankopplung zur Ausnutzung der rauschärmeren hybriden Modenkopplung ist die Pulsquelle **PS** zur deutlichen Reduzierung parasitärer Kapazitäten durch Ätzung eines tiefen Trenngrabens **ST** auf beiden Seiten in ihrer lateralen Ausdehnung stark eingeschränkt. Die so entstandene schmale (≤ 10 µm) Laserrippe **LR** enthält den Laserwellenleiter **LWG** der Pulsquelle **PS** und seitlich angewachsene Stromblockierungsschichten (vgl. Figur 4), die für eine optimale Frequenzankopplung aus semi-isolierendem Halbleitermaterial (z.B. InP:Fe) bestehen können. Das für den externen Hochfrequenzanschluss an der Absorbersektion **SAS** vorgesehene Bondpad **BP** befindet sich im Vergleich zu den anderen Bondpads **BP** für die DC-Anschlüsse auf der gegenüberliegenden Seite der Laserrippe **LR.**

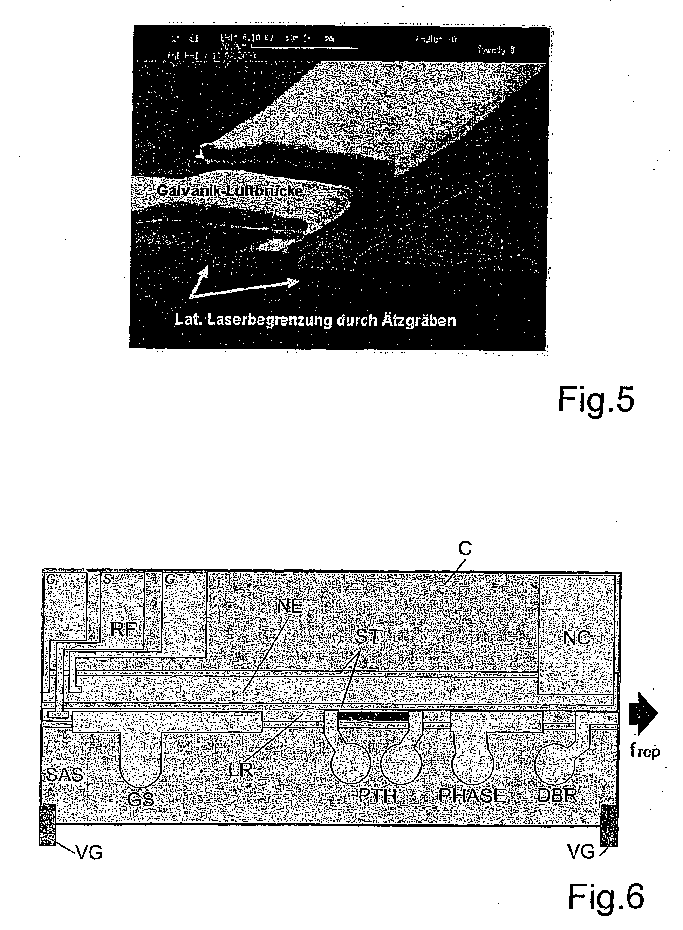

In der **Figur 4** ist eine schematische Querschnitts-Darstellung der Pulsquelle **PS** mit der Laserrippe **LR,** dem Wellenleiter-Schichtaufbau **SCL** (Substrat S, z.B. n⁺-InP, Pufferschicht **P,** stromblockierende Schichten **CBL,** z.B. n⁻-InP, Si-InP:Fe/nInP:Si oder p-InP:Zn/n-InP:Si, Deckschicht **CLD,** Kontaktschichten **CL,** z.B. p-GaInAs/GaInAsP, und Passivierung **PA),** den geätzten Trenngräben **ST** und einer galvanisch verstärkten Kontaktführung von der Laserrippe **LR** zum elektrisch anschließenden Bondpad **BP** mittels Luftbrücke **ABC** dargestellt. Da sich im gewählten Ausführungsbeispiel der monolithisch integrierte Wellenleiter-Schichtaufbau **SCL** auf einem n-dotierten Substrat **S** befindet, ist der gemeinsame N-Kontakt **NC** auf der Substratrückseite angeordnet. Alle metallischen Kontaktführungen von den Bondpads **BP** (Anschlusskontakte) zur Laserrippe **LR** sind auf dem den Wellenleiter-Schichtaufbau **SCL** tragenden Chip **C** galvanisch verstärkt und werden als Luftbrücken **ABC** über die zuvor geätzten Gräben **TS** geführt (vgl. Figur 5). Diese Art der Kontaktierung erlaubt eine effiziente, d.h. niederohmige Stromzuführung über die Trenngräben **ST,** die insbesondere für eine effiziente Hochfrequenzankopplung an die von extern zu modulierenden Sektionen notwendig ist.

Die **Figur 5** zeigt ein Rasterelektronenmikroskop-Foto der in Figur 4 erläuterten galvanisch verstärkten Kontaktführung mit Luftbrücke zur Laserrippe sowie des durch die Strukturierung von tiefen Ätzgräben lateral eingeschränkten Laserwellenleiters.

In der **Figur 6** ist eine schematische Darstellung des auf der Oberfläche des Chips **C** platzierten gemeinsamen N-Kontaktes **NC** und die koplanare Kontaktführung über eine N-Elektrode **NE** zum extern anzusteuemden Absorber **SAS** in Aufsicht bei Verwendung eines semi-isolierenden Substrates (z.B. InP:Fe) dargestellt. Dabei ist die koplanar geführte N-Elektrode **NE** ebenfalls von Trenngräben **ST** begrenzt, wobei zur Laserrippe **LR** hin ein gemeinsamer Trenngraben **ST** genutzt werden kann.

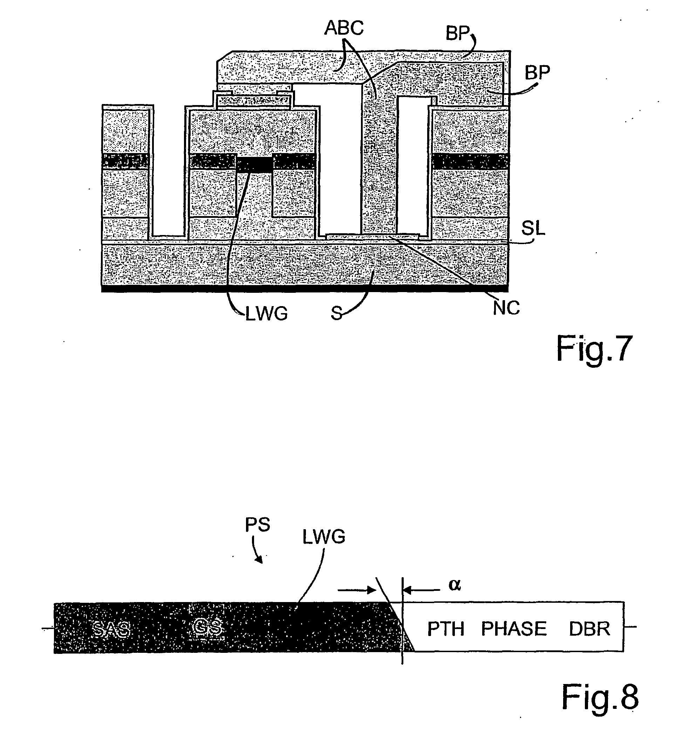

Alternativ kann bei Verwendung eines semi-isolierenden Substrates S (z.B. InP:Fe) der gemeinsame und zuvor beschriebene N-Kontakt **NC** auf dem Chip **C** strukturiert werden (vgl. Figur 7). Hierfür wird einer der beiden Trenngräben **ST** der Laserrippe **LR** zur lateralen Begrenzung des Laserstreifens entsprechend der erforderlichen Kontaktbreite größer ausgelegt. Die nasschemische Ätzung der Trenngräben **ST** endet dann auf einer dünnen Ätzstoppschicht **SL** (z.B. GalnAsP), die zu Beginn des Herstellungsprozesses in den Wellenleiter-Schichtaufbau **SCL** implementiert wurde und die weiterhin als Kontaktschicht für den nachfolgend zu strukturierenden, gemeinsame N-Kontakt **NC** dient. Die Stromzuführung zu den p- Metallisierungen der kontinuierlich (DC) anzusteuernden Sektionen **GS, PTH, PHASE, DBR** erfolgt weiterhin durch die Luftbrücken **ABC** über den schmalen Trenngraben **ST.** Die Kontaktführung zur hochfrequent (HF,RF) anzusteuernden Sektion (hier der Absorbersektion **SAS)** wird in einer Koplanar-Anordnung ausgelegt und mit galvanisch verstärkten Luftbrücken **ABC** versehen. Die das hochfrequente Signal führende Luftbrücke **(S)** zur Laserrippe **LR** überspannt den breiten kontaktierenden Trenngraben **ST.** Die Ground-Metallisierungen **(G)** der Koplanar-Anordnung werden - ebenfalls als Luftbrücken - auf den N-Kontakt **NC** am Boden des kontaktierenden Trenngrabens **ST** geführt. In gleicher Weise wird der gemeinsame N-Kontakt **NC** für die anderen, DC-betriebenen Sektionen an den vorzusehenden Bondpad **BP** geführt. Der gesamte Herstellungsaufwand wird durch diesen Aufbau lediglich um einen Prozessschritt (Deposition und Strukturierung des N-Kontaktes **NC** im Trenngraben **ST)** erhöht.

Die **Figur 7** zeigt die Struktur gemäß Figur 6 im Querschnitt durch den Laserstreifen im Bereich der Laserrippe **LR** mit den galvanisch verstärkten Kontaktzuführungen, wenn bei Verwendung eines semi-isolierenden Substrates **S** der gemeinsame N-Kontakt **NC** auf dem Chip **C** angeordnet werden muss. Eine Beschreibung der hier nicht gekennzeichneten Strukturen und Schichten ist der Beschreibung zu Figur 4 zu entnehmen.

In der **Figur 8** ist eine Aufsicht auf den Laserwellenleiter **LWG** am Übergang zwischen aktivem Laserbereich (dunkel) und passivem Laserbereich (hell) dargestellt. Zur Unterdrückung von Reflexionen am Übergang zwischen dem aktiven und dem passiven Laserbereich ist der aktive Laserbereich lateral um einen Winkel α, bevorzugt zwischen 7° und 12°, geneigt. Die schematische Aufsicht zeigt den durch eine Maske abgedeckten aktiven Laserbereich, der am Ende des Herstellungsprozesses die Verstärker- und Absorbersektion **GS, SAS** enthält, mit einer lateralen Neigung an einer Seite. An diese Grenzfläche werden mittels selektiver Epitaxie - nach Entfernung der Laserschichten außerhalb des dargestellten Maskenbereiches - die Halbleiterschichten für den passiven Laserbereich der monolithischen Pulsquelle **PS** gewachsen.

Da die Pulsfolgefrequenz **f**ᵣₑₚ modengekoppelter Halbleiterlaser von der optischen Resonatorlänge, die der Längensummation der vorhandenen Sektionen mit den entsprechenden effektiven optischen Indizes entspricht, ist die Herstellung von monolithisch integrierten Pulsquellen mit exakt definierten geometrischen Resonatorlängen eine entscheidende Voraussetzung. Dies gilt insbesondere für Strukturen, die im Rahmen von Anwendungen in einem Kommunikationsnetz zur Netzsynchronisation eine präzise, vorgegebene Pulsfolgefrequenz **f**_{**rep**} aufweisen müssen (z.B. Telekommunikations- und Datenübertragungssysteme). Um diese Forderung erfüllen zu können, können die Laserresonatoren durch die Kombination von einer Strukturierung tief geätzter, V-förmiger Spaltgräben auf dem Wafer mit einem maschinell unterstützten Spaltprozess nach der Bauelementfertigstellung hergestellt werden. So lassen sich einzelne Barren aus dem Wafer herausspalten, auf denen mehrere Laser parallel nebeneinander angeordnet sind und deren Länge der geforderten Resonatorlänge entspricht. Auf dem Wafer werden im Herstellungsprozess rechteckige Fenster in eine bereits vorhandene Oberflächen-Passivierungsschicht mittels Photolithographie und Trockenätztechnik strukturiert. Zur Festlegung der Resonatorlänge werden zwei solcher Fenster bzw. Fensterreihen lithographisch definiert, deren Abstand bezüglich ihrer Mittellinien die endgültige Resonatorlänge mit hoher Genauigkeit festlegt. Durch den sich anschließenden nasschemischen Ätzprozess entsteht eine in die Tiefe symmetrisch verlaufende, V-förmige Grube, deren Spitze mit der Mittellinie der zuvor definierten Fenster zusammenfällt. Die Tiefe der Gruben wird durch die Breite der Ätzfenster, das zu ätzende Halbleitermaterial und die Wahl der einzusetzenden Ätzlösung festgelegt. Mit den so strukturierten Spaltgräben (**VG**, vgl. Abbildung 3) wurden in einem ersten Test sechs Barren mit insgesamt 220 monolithisch integrierten 40 GHz-Pulsquellen auf GaInAsP/InP-Basis vereinzelt, deren Resonatorlängen nur um (0,5 ± 0,4) µm von der lithographisch vorgegebenen Länge (Lo= 1100,0 µm) abweichen. Die in diesem Fall erzielte Spaltgenauigkeit ist mit Frequenzverschiebung unterhalb von 50 MHz verbunden und könnte bereits durch die erzielten Frequenzabstimmbereiche auf dem Chip ohne zusätzliche Maßnahmen kompensiert werden.

Für eine größere Genauigkeit zur Erzielung präziser Resonatorlängen (z.B. in Hinblick auf die Herstellung von monolithischen Halbleiterlaser-Pulsquellen mit Pulsfolgefrequenzen von ≥ 40 GHz) können die oben implementierten Spaltgruben noch mit lokal auf dem Chip strukturierten Resonatorspiegeln kombiniert werden.

### Bezugszeichenliste

- **ABC**: Luftbrücke
- **BP**: Bondpad (Anschlusskontakt)
- **C**: Chip
- **CBL**: stromblockierende Schicht
- **CL**: Kontaktschicht
- **CLD**: Deckschicht
- **DBR**: Gittersektion
- **GS**: Verstärkersektion
- **f**ᵣₑₚ: Pulsfolgefrequenz
- Δ**f**ᵣₑₚ: Verschiebung der Pulsfolgefrequenz
- **I**_{gain}: Verstärkerstrom
- Δ**I**_{gain}: Verschiebung des Verstärkerstroms
- Verhältnis L_{gain} / L_{absorb}
- **L**_{gain}: Länge Verstärkersektion
- **L**_{absorb}: Länge Absorbersektion
- **LA**: Linearanordnung
- **LR**: Laserrippe
- **LWG**: Laserwellenleiter
- **NC**: N-Kontakt
- **NE**: N-Elektrode
- **n**-**type**: n-dotiert
- **p-type**: p-dotiert
- **PA**: Passivierung
- **PC**: P-Kontakt
- **PHASE**: Phasensektion
- **PS**: Pulsquelle
- **PTH**: Heizstreifensektion
- **S**: Substrat
- **SAS**: sättigbare Absorbersektion
- **SCL**: Wellenleiter-Schichtaufbau
- **SL**: Ätzstoppschicht
- **ST**: Trenngraben
- **U**_{**absorb**}: Absorberspannung
- **VG**: V-förmige Spaltgrube

## Patentansprüche

1. Modengekoppelte Halbleiterlaser-Pulsquelle für den Ultrahochfrequenzbereich in monolithisch integriertem Wellenleiter-Schichtaufbau auf InP-Basis mit einem Abstimmungsbereich Δfᵣₑₚ für die erzeugte Pulsfolgefrequenz fᵣₑₚ mit zumindest einer von einem Verstärkerstrom I_{gain} durchflossenen Verstärkersektion der gewählten Länge L_{gain} und einer sättigbaren Absorbersektion der gewählten Länge L_{absorb} mit einer angelegten Absorberspannung U_{absorb} als aktivem Laserbereich in Linearanordnung sowie mit einem n-leitenden- und einem p-leitenden Anschlusskontakt,
**dadurch gekennzeichnet, dass**
der Abstimmungsbereich Δfᵣₑₚ der Pulsfolgefrequenz fᵣₑₚ durch das gewählte Längenverhältnis r der Länge L_{gain} der Verstärkersektion zur Länge L_{absorb} der Absorbersektion nach der Geradengleichung Δfᵣₑₚ = c - m· Γ mit den streuwertbehafteten Konstanten c= 304 ± 50 und m = 61,4 ± 5 bei einer jeweiligen Änderung ΔI_{gain} des Verstärkerstroms I_{gain} um 70 mA und einer simultanen Anpassung der voreingestellten Absorberspannung U_{absorb} zwischen - 1 V und - 4 V zur Erzeugung konstanter, minimaler Pulsbreiten kontinuierlich definiert ist und dass L_{gain} und L_{absorb} für die Halbleiterlaser - Pulsquelle so gewählt werden, daß sie der Geradungleichung genügen.

2. Modengekoppelte Halbleiterlaser-Pulsquelle nach Anspruch 1,
**dadurch gekennzeichnet, dass**
in der passiven Sektion der Linearanordnung (LA) eine Gittersektion (DBR) zur Einstellung der Emissionswellenlänge der Halbleiter-Pulsquelle (PS) vorgesehen ist.

3. Modengekoppelte Halbleiterlaser-Pulsquelle nach Anspruch 1 oder 2,
**dadurch gekennzeichnet, dass**
in der passiven Sektion der Linearanordnung (LA) eine Phasensektion (PHASE) oder/und eine Heizstreifensektion (PTH) zur weiteren Abstimmung der Pulsfolgefrequenz fᵣₑₚ vorgesehen ist.

4. Modengekoppelte Halbleiterlaser-Pulsquelle nach einem der vorangehenden Ansprüche 1 bis 3,
**dadurch gekennzeichnet, dass**
durch eine Beaufschlagung des Anschlusskontaktes (BP) der Absorbersektion (SAS) mit einem extern erzeugten Hochfrequenzsignal zur Ausbildung der Funktion des hybriden Modenkoppelns ausgelegt ist.

5. Modengekoppelte Halbleiterlaser-Pulsquelle nach einem der vorangehenden Ansprüche 1 bis 4,
**dadurch gekennzeichnet, dass**
eine laterale Begrenzung der Pulsquelle (PS) auf eine Laserrippe (LR) mit vergrabenem Laserwellenleiter (LWG) durch zwei die Rippenbreite definierende parallele Trenngräben (ST) vorgegebener Tiefe durchgeführt ist.

6. Modengekoppelte Halbleiterlaser-Pulsquelle nach Anspruch 5,
**dadurch gekennzeichnet, dass**
alle metallischen Anschlusskontakte (BP) im Bereich der Trenngräben (ST) als galvanisch verstärkte Luftbrücken (ABC) ausgebildet sind.

7. Modengekoppelte Halbleiterlaser-Pulsquelle nach Anspruch 5 oder 6,
**dadurch gekennzeichnet, dass**
der n-leitende Kontakt (NC) auf der Oberseite des ein semi-isolierendes Substrat (S) umfassenden Wellenleiter-Schichtaufbaus (SCL) strukturiert ist und über eine in eine der beiden Trenngräben (ST) eingreifende Luftbrücke (ABC) kontaktiert ist.

8. Modengekoppelte Halbleiterlaser-Pulsquelle nach Anspruch 7,
**dadurch gekennzeichnet, dass**
der n-leitende Kontakt (NC) in Koplanar-Anordnung ausgeführt ist.

9. Modengekoppelte Halbleiterlaser-Pulsquelle nach einem der vorangehenden Ansprüche 2 bis 8,
**dadurch gekennzeichnet, dass**
der aktive Laserbereich gegenüber dem passiven Laserbereich im Laserwellenleiter (LWG) lateral um einen Winkel α unterhalb von 15° geneigt ist.

10. Modengekoppelte Halbleiterlaser-Pulsquelle nach einem der vorangehenden Ansprüche 1 bis 9,
**dadurch gekennzeichnet, dass**
der Wellenleiter-Schichtaufbau (SCL) als zumindest ein genau längendefinierter Barren durch Implementation von zumindest v-förmigen Spaltgräben (VG) im Substrat (S) ausgebildet ist.

## Claims

1. Mode-locked semiconductor laser pulse source for the ultra-high frequency range in monolithically integrated waveguide layer construction on an InP basis with a tuning range Δfᵣₑₚ for the generated pulse repetition frequency fᵣₑₚ with at least one gain section, through which a gain current I_{gain} flows, of the selected length L_{gain} and one saturable absorption section of the selected length L_{absorb} with an applied absorption voltage U_{absorb} as an active laser area in linear arrangement as well as with one n-type and one p-type terminal contact, **characterized in that** the tuning range Δfᵣₑₚ of the pulse repetition frequency fᵣₑₚ is continuously defined by the selected length ratio Γ of the length L_{gain} of the gain section to the length L_{absorb} of the absorption section according to the linear equation Δfᵣₑₚ = c - m· r with the constants c = 304 ± 50 and m = 61.4 ± 5 encumbered with variance coefficients with a respective change ΔI_{gain} in the gain current I_{gain} of 70 mA and a simultaneous adjustment of the preset absorption voltage U_{absorb} between - 1 V and - 4 V for the production of constant, minimal pulse widths, and that L_{gain} and L_{absorb} are selected for the semiconductor laser pulse source such that they satisfy the linear equation.

2. Mode-locked semiconductor laser pulse source according to claim 1, **characterized in that** in the passive section of the linear arrangement (LA) a grating section (DBR) is provided for setting the emission wavelength of the semiconductor pulse source (PS).

3. Mode-locked semiconductor laser pulse source according to claim 1 or 2, **characterized in that** in the passive section of the linear arrangement (LA) a phase section (PHASE) and/or a heating strip section (PTH) is provided for further tuning of the pulse repetition frequency fᵣₑₚ.

4. Mode-locked semiconductor laser pulse source according to one of the preceding claims 1 to 3, **characterized in that** activation of the terminal contact (BP) of the absorption section (SAS) with an externally generated high-frequency signal is rated for forming the function of hybrid mode-locking.

5. Mode-locked semiconductor laser pulse source according to one of the preceding claims 1 to 4, **characterized in that** a lateral limiting of the pulse source (PS) to a laser rib (LR) with buried laser waveguide (LWG) is executed by two parallel separation channels (ST) of predetermined depth defining the rib width.

6. Mode-locked semiconductor laser pulse source according to claim 5, **characterized in that** all metal terminal contacts (BP) in the area of the separation channels (ST) are formed as galvanically reinforced air bridges (ABC).

7. Mode-locked semiconductor laser pulse source according to claim 5 or 6, **characterized in that** the n-type contact (NC) is structured on the upper side of the waveguide layer construction (SCL) comprising a semiinsulating substrate (S) and is contacted via an air bridge (ABC) intervening in one of the two separation channels (ST).

8. Mode-locked semiconductor laser pulse source according to claim 7, **characterized in that** the n-type contact (NC) is executed in coplanar arrangement.

9. Mode-locked semiconductor laser pulse source according to one of the preceding claims 2 to 8, **characterized in that** the active laser area is inclined relative to the passive laser area in the laser waveguide (LWG) laterally by an angle α of less than 15°.

10. Mode-locked semiconductor laser pulse source according to one of the preceding claims 1 to 9, **characterized in that** the waveguide layer construction (SCL) is formed as at least a precisely length-defined bar by implementation of at least V-shaped gap channels (VG) in the substrate (S).

## Revendications

1. Source d'impulsions de laser semi-conducteur à couplage de modes pour la gamme des ultra-hautes fréquences dans une structure de couches de guide d'ondes intégré de manière monolithique à base InP, comprenant une zone d'accord Δfᵣₑₚ pour la fréquence d'impulsions produite fᵣₑₚ, avec comme zone de laser active en montage linéaire au moins une section d'amplification de longueur L_{gain} choisie traversée par un courant d'amplification I_{gain} et une section d'absorption saturable de longueur L_{absorb} choisie avec une tension d'absorption U_{absorb} appliquée, ainsi qu'un contact de connexion à conducteur n et un à conducteur p,
**caractérisée en ce que**
la zone d'accord Δfᵣₑₚ de la fréquence d'impulsions fᵣₑₚ est définie en continu par le rapport des longueurs choisi Γ de la longueur L_{gain} de la section d'amplification sur la longueur L_{absorb} de la section d'absorption suivant l'équation linéaire Δfᵣₑₚ = c - m Γ, avec les constantes de valeurs c = 304 ± 50 et m = 61,4 ± 5 pour une modification respective ΔI_{gain} du courant d'amplification I_{gain} de 70 mA et une adaptation simultanée de la tension d'absorption préétablie U_{absorb} entre - 1 V et - 4 V afin de produire des largeurs d'impulsions minimales constantes, et les valeurs L_{gain} et L_{absorb} pour la source d'impulsions de laser semi-conducteur sont choisies de manière à satisfaire à l'équation linéaire.

2. Source d'impulsions de laser semi-conducteur à couplage de modes selon la revendication 1,
**caractérisée en ce que**
dans la section passive du montage linéaire (LA), on prévoit une section de grille (DBR) pour régler la longueur d'ondes d'émission de la source d'impulsions à semi-conducteur (PS).

3. Source d'impulsions de laser semi-conducteur à couplage de modes selon la revendication 1 ou 2,
**caractérisée en ce que**
dans la section passive du montage linéaire (LA), on prévoit une section de phase (PHASE) et/ou une section de bandes calorifères (PTH) pour un autre accord de la fréquence d'impulsions fᵣₑₚ.

4. Source d'impulsions de laser semi-conducteur à couplage de modes selon l'une des revendications précédentes 1 à 3,
**caractérisée en ce qu'**
une sollicitation du contact de connexion (BP) de la section d'absorption (SAS) est effectuée à l'aide d'un signal à haute fréquence produit de manière externe pour réaliser la fonction du couplage de modes hybrides.

5. Source d'impulsions de laser semi-conducteur à couplage de modes selon l'une des revendications précédentes 1 à 4,
**caractérisée en ce qu'**
une limitation latérale de la source d'impulsions (PS) est réalisée sur une rainure de laser (LR) avec un guide d'ondes laser enterré (LWG) par deux tranchées de séparation parallèles (ST) définissant la largeur de la rainure de profondeur prédéterminée.

6. Source d'impulsions de laser semi-conducteur à couplage de modes selon la revendication 5,
**caractérisée en ce que**
tous les contacts de connexion métalliques (BP) sont réalisés dans la zone des tranchées de séparation (ST) sous forme de ponts aériens renforcés de manière galvanique (ABC).

7. Source d'impulsions de laser semi-conducteur à couplage de modes selon la revendication 5 ou 6,
**caractérisée en ce que**
le contact à conducteur n (NC) est structuré sur la face supérieure de la structure de couches du guide d'ondes (SCL) comprenant un substrat (S) semi-isolé, et est en contact avec un pont aérien (ABC) s'engageant dans une des deux tranchées de séparation (ST).

8. Source d'impulsions de laser semi-conducteur à couplage de modes selon la revendication 7,
**caractérisée en ce que**
le contact à conducteur n (NC) est réalisé dans un montage coplanaire.

9. Source d'impulsions de laser semi-conducteur à couplage de modes selon l'une des revendications précédentes 2 à 8,
**caractérisée en ce que**
la zone laser active est inclinée latéralement d'un angle α inférieur à 15° par rapport à la zone laser passive dans le guide d'ondes laser (LWG).

10. Source d'impulsions de laser semi-conducteur à couplage de modes selon l'une des revendications précédentes 1 à 9,
**caractérisée en ce que**
la structure de couches du guide d'ondes (SCL) est réalisée au moins sous la forme d'une barre de longueur précisément définie en réalisant au moins des tranchées de fentes en forme de V (VG) dans le substrat (S).
